# EUROPEAN PATENT APPLICATION

(11) **EP 0 834 920 A1**
(43) Date of publication of application: **08.04.1998**
(21) Application number: 97307832.2
(22) Date of filing: 03.10.1997
(51) Int. Cl.: H01L 23/532, H01L 23/522

(54) **Improvements in or relating to semiconductor device metallization and interconnects**

(30) Priority: 03.10.1996 US 27843 P
(71) Applicant: TEXAS INSTRUMENTS INC., Dallas, Texas 75243 (US)
(72) Inventor: Graas, Carole D., Garland, Texas 75265 (US)
(74) Representative: Williams, Janice

(57) **Abstract**

Via reliability failure in ULSI devices having aluminum leads is reduced by forming an intermetallic cap or pad 14e layer of metal that is localized to the via. A localized via pad 14e or cap provides improved electromigration characteristics while minimizing sheet resistance.

## Description

### FIELD OF THE INVENTION

This invention is in the field of semiconductor devices and more particularly, it relates to the metallization and interconnects in such semiconductor devices.

### BACKGROUND OF THE INVENTION

The density of devices fabricated on semiconductor substrates continues to increase due in large part to decreasing feature sizes. For example, today's ultra large scale integrated (ULSI) devices, such as 16 megabit (Mb) dynamic random access memories (DRAMs) (illustrated in U.S. Pat. No. 5,202,279)issued to Chung et al.) are built using 0.5 micron technology while tomorrow's 64 MB DRAM are projected to incorporate 0.35 micron features. In order for miniaturization to continue, the processing used to manufacture and ensure the reliability of such sub-micron devices must continually be challenged, developed, and refined.

One important semiconductor processing area in need of improvement is metallization. Chapter 9, on pages 375--421, of VLSI Technology Second Edition, 1988, by S.M. Sze of AT&T Bell Laboratories discusses metallization as does Chapter 10, on pages 518--578, of Semiconductor Integrated Circuit Processing Technology, 1990, by W. R. Runyan and K. E. Bean of Texas Instruments.

Metallization provides interconnection between contacts on devices and between devices and the outside world. To make electrical connection between devices and the outside world, multilevels of metal are used. Typically, a recess (hole or via) is bored through a dielectric covering a first level of metal. The hole is filled with conductive material and a second level of metal is applied. The conductive material in the via provides electrical connection between the first and the second levels of metal.

As device feature sizes shrink, the aspect ratio of the vias increase. The aspect ratio is obtained by dividing the depth of the via by the width (diameter) of the via. Ultra Large Scale Integrated (ULSI) circuit devices such as the above described 16 Mb DRAM have vias around 1.5 microns deep and around 0.6 microns wide, thus diving them high aspect ratios of the order of about 2.5.

In ULSI multilevel metallization systems, interconnect via reliability performance problems can be associated with many process/design related factors. In particular, increasing via aspect ratios tend to emphasize via etch and clean up related issues. Etch residues produced by the highly-passivating etch chemistries such as CHF₃, CF₄, and C₂F₆ are becoming harder to remove completely, and more aggressive solvents have to be used. In the case of aluminum leads, this puts the exposed aluminum lead surfaces to a greater risk of damage. Tighter design rules require the use of highly directional and energetic reactive ion etch plasmas which then also expose the underlying aluminum to erosion or trenching by lack of selectivity. A trend towards all dry post via etch cleanup processes generally prevent solvent induced defects but may create further damage to the aluminum surface by oxidation. However, attempts to sinter the newly-etched via holes to burn off organic residues put the aluminum at risk of hillocking into the vias.

Electromigration undesirably affects via interconnect performance. Electromigration induced failure is probably the most important mode of failure in aluminum lines. Prior attempts to improve electromigration performance have involved utilizing antireflection coating (ARCs) capping layers. These ARCs are typically thin layers of various refractory metals such as TiN and TiW. The capping layers have been put above and below the aluminum leads to improve electromigration characteristics as discussed in the following papers: "A Highly Reliable Aluminum Metallization For Micron and Submicron VLSI Applications" by Shen et al., June 1986 V-MIC Conference; "Electromigration Improvements with Titanium Underlay and Overlay in Al(Cu) Metallurgy" by Estabil et al., June 1991 VMIC Conference; and, "Texture Effects On The Electromigration Behavior of Layered Ti/AlCu/Ti Films" by Rodbell et al. 1992 Materials Research Society Symposium Volume 265.

Despite providing improvements in electromigration, these thin capping layers still do not adequately protect the portion of the aluminum leads lying underneath high aspect ratio vias. The etch chemistries are typically not selective to the anti-reflective coatings and sine these coatings are very thin, it is possible to either locally "punch-through" or completely etch into the underlying aluminum when etching the vias. This provides undesirable higher via resistance and greater standard deviation across a semiconductor wafer surface. Etching into the aluminum during the via etch exposes the aluminum to contamination from the etching plasma, the ambient, the cleaning agents necessary to remove etch residues, etc. Locally punching through, or "pinholing" the capping layer creates a rough surface at the bottom of the vias. Because of their relatively poor step coverage, the thin barrier layers subsequently deposited to coat the via holes will then tend to exhibit defects. This will reduce their effectiveness in appropriately protecting the underlying aluminum from chemical damage by gases used in subsequent processes (e.g. during the formation of the via plugs).

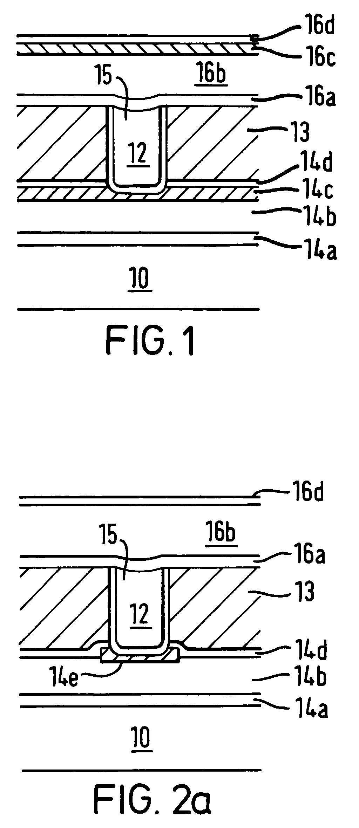

United States Patent No. 5,360,995 issued 11/01/94 provides important improvements in electromigration performance of multilevel interconnect systems by providing a buffered intermetallic layer on top of an aluminum lead. Prior art FIG. 1 shows a semiconductor wafer 10 having a via 12 filled with conductive material 15 coupling a first layer of metal 14 and a second level of metal 16 formed by a method disclosed in U.S. Pat. No. 5,360,995. A capped aluminum lead is exemplary of first metal layer 14. Layer 14a is a thin barrier layer; TiN, TiW and Ti are exemplary. Layer 14b is a thick conductor layer; AlSiCu is exemplary. Layer 14c is the intermetallic layer which extends the length of the lead; TiAl₃ is exemplary. Layer 14d is the thin anti-reflective coating; TiN is exemplary. When the via etch occurs, the intermetallic layer functions as an etch stop resulting in the etch terminating in the intermetallic as opposed to terminating in the aluminum lead.

Further studies have revealed that while the above technique provides improvements in via electromigration mean time to failure, the buffered capping layer may tend to cause relatively high lead sheet resistance. It is believed that this results from: (1) the titanium atoms diffusing into the grain boundaries of the quasi-bamboo aluminum lead structure; and (2) from the reduction in aluminum cross-section resulting from the consumption of Al atoms during the intermetallic formation reaction. Increasing the thickness of the aluminum film to compensate for this results in an overall thicker thin-film stack to form the interconnect. Tall interconnect lines have lower signal propagation speed performances because of increased capacitance.

What is therefore needed is a technique which provides the advantages of electromigration improvements without tending to cause relatively high sheet resistance.

It is accordingly an object of the invention to provide such a technique.

Other objects and advantages will be apparent to those of ordinary skill in the art having reference to the following specification and drawings.

### SUMMARY OF THE INVENTION

Respective aspects of the present invention are set forth in claims 1, 3 and 4.

An improved metal junction for semiconductor devices includes a lead having an intermetallic layer localized to the vias in the form of a via pad or a via cap. The localized via pad or via cap (which may be asymmetrical) provides the benefits of via electromigration improvements while minimizing high lead sheet resistance. As a pad, the intermetallic layer protects the underlying conductor during via etch by providing a buffer that the etch may stop within. The pad may be created by forming a thin metal layer between the conductor and an antireflection coating. Heating the thin metal layer causes it to react with the conductor and form the intermetallic. When planarizing the patterned metal conductors with a dielectric such as spin on glass, curing the spin on glass sufficiently heats the thin metal layer to facilitate the reaction. If no curing process is used and the intermetallic layer is not formed prior to via etch, the pad is effective in repairing damage caused to the aluminum during the etch or the plug formation sequence. In this case the intermetallic is formed during a back-end of line sinter process which is usually performed at about 400 °C.

### BRIEF DESCRIPTION OF THE DRAWINGS

The present invention will now be further described, by way of example, with reference to the accompanying drawings in which:
FIG. 1 is a prior art enlarged cross section side view drawing illustrating a metal interconnect system.
FIG. 2a is an enlarged cross section side view drawing illustrating an embodiment of a metal interconnect system in accordance with an embodiment of the invention herein where the via 12 goes through the ARC layer 14d.
FIG. 2b is an enlarged cross section side view drawing illustrating an embodiment of a metal interconnect system in accordance with the invention herein where the via 12 stops in the ARC layer 14d.
FIG. 3a is a cross section side drawing illustrating an asymmetrical via pad.
FIG.s 3b and 3c are top view drawings of the asymmetrical via pad of FIG. 2.
FIG.s 4- 10 are cross sectional drawings illustrating successive stages in fabricating the via pad of FIG. 2
FIG.s 11 and 12 are cross section end view drawing illustrating formation of via 12 of FIG. 2
FIG. 13 is a cross section side view drawing of a multilevel metal system having a via cap;
FIG. 14 is a cross section side view drawing of a multilevel metal system having a via cap; and
FIG. 15 is a cross section side view drawing of a multilevel metal system employing both via pad and via cap where the via plug and interconnect are made of the same alloy.

### DETAILED DESCRIPTION OF PREFERRED EMBODIMENT

FIG.s 2a and 2b are enlarged cross section side view drawings illustrating a capped multilevel metallization structure wherein a semiconductor wafer 10 has a via 12 filled with conductive material 15 coupling a first layer of metal 14 and a second level of metal 16. Comparing FIG. 2a with prior art FIG. 1, one finds a via "pad" 14e only underneath via 12 as opposed to the continuous intermetallic layer 14c on top of conductor 14b. Limiting the intermetallic to only the area near each via accomplishes both improving electromigration while meeting a low lead sheet resistance target.

In FIG.s 2a and 2b, semiconductor wafer 10 has active devices (not illustrated) formed therein. Illustrative active devices include, for example, submicron devices such as 16 Mb DRAMs built to 0.5 micron design rules and 64 Mb DRAMs built to even smaller 0.35 micron design rules. It is understood that first metal layer 14 couples to the active devices generally through contacts which are also not illustrated.

In FIG.s 2a and 2b, via 12 is representative of a high aspect ratio via. In a 0.5 micron device, it may be around 1.5 microns deep and around 0.6 microns wide. It is filled with conductive material 15. Conductive material 15 thus forms electrical connection between the underlying first metal level 14 and the overlying second metal level 16. While different conductive materials are suitable to fill via 12, in this example tungsten forms conductive material 15. The tungsten filled via 12 is referred to as a tungsten plug. Aluminum, copper, an aluminum alloy, or a copper alloy is exemplary of other plug conductors and of other conductors. A barrier layer 16a that forms part of metal layer 16, described with more particularity below, lines via 12 and thus conductive material 15 lies on top of barrier layer 16a inside via 12.

In FIG.s 2a and 2b, metal layer 14 and metal layer 16 are generally similarly constructed stacked metal layers. There are differences, however, such as layer 14 having via pads 14e. Discussion follows with respect to metal layer 14, it being understood that generally the same discussion applies to metal layer 16 except for the discussion with respect to the via pads 14e. Metal layer 14 is comprised of a bottom layer 14a, a second layer 14b covering the bottom layer 14a, a third layer 14e on the second layer 14b only where vias 12 are located, and a top layer 14d. Layer 14a is a thin barrier layer of metal. Suitable barrier metals include single layer of metals such as titanium nitride TiN, titanium tungsten TiW, titanium Ti etc. and multilayers such as titanium/titanium nitride Ti/TiN. These barrier metals would be suitable for tungsten, aluminum and copper plugs. In 0.5 design rules, layer 14a may be around 1000 angstroms while in 0.35 micron design rules, it may be around 500 angstroms thick. Metal layer 14b is thick conductor layer. Exemplary is an aluminum alloy that may contain a small amount of copper and silicon, such as around 0.5% copper and around 1% silicon. Metal layer 14b may be in the range of about 4000--8000 angstroms thick for both 0.5 and 0.35 micron design rules.

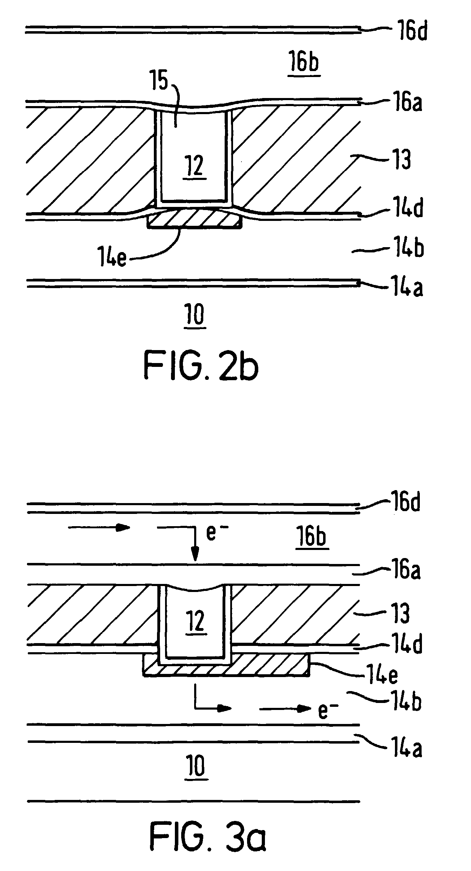

In FIG. 2a, pad 14e is local to the via 12 and is formed of a thin intermetallic layer. It may be formed by the below described process and advantageously provides a "safety margin" during via etch so that if the etch should overetch (FIG. 2a) or pinhole the ARC (FIG. 2b), it will etch into the pad precursor or the intermetallic and not into the underlying layer 14b. When layer 14b is an aluminum alloy, intermetallic layer 14e can be formed by metals that react with aluminum, such as, but not limited to, titanium Ti, zirconium Zr, hafnium Hf, chromium Cr, molybdenum Mo, tungsten W, copper Cu, palladium Pd, platinum Pt, and nickel Ni. For example, Ti reacts with aluminum to form TiAl₃. Metal layer 14d is also a thin layer. It provides an anti-reflective coating (ARC) required at sub-half micron geometries for metal stack 14. TiN is exemplary of a suitable ARC coating. Typical thickness for layer 14d is about 300 angstroms.

Comparing prior art FIG. 1 with FIG. 2a, it is seen that for a given lead stack thickness 14, FIG. 2a allows the aluminum conductor portion 14b to be thicker (which provides lower sheet resistance), while also slightly decreasing the via aspect ratio (which helps improving the via filling process). The aluminum conductor portion 14b in FIG. 2a is thicker than the aluminum conductor portion 14b of prior art FIG. 1 because FIG. 2a has no continuous intermetallic layer 14c extending the length of the conductor; rather, the only intermetallic in conductor 14 of FIG. 2 is that associated underneath the via 12. Typical thicknesses for pad 14e would be between 200-400 angstroms. The intermetallic pad 14e has a polycrystalline configuration.

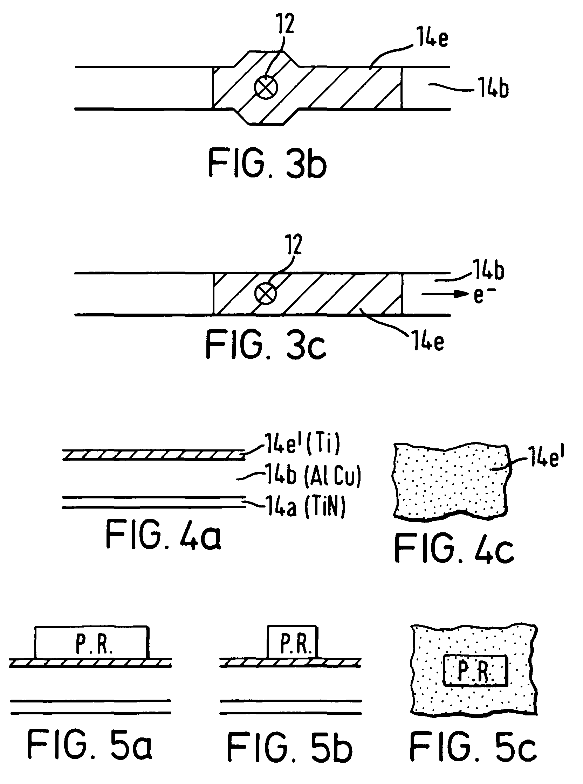

The via pad can extend along the lead on either side of the via depending on the voiding mechanism active for a particular via as illustrated in the enlarged cross section of FIG. 3a and in the top views afforded by FIG.s 3b and 3c. In FIG. 3a, for example, if the electrons flow from the top left to the bottom right, then the pad 14e can be designed asymmetrically such that a larger portion of the pad is located on the right hand side of via 12. The via pad dimensions can be fixed individually on the via pad reticle for a specific semiconductor chip according to the direction of electron flow designed for each via. The pad should simply extend in the direction of the electron flux divergence underneath each via. The length of the extension can be determined individually according to the chip's reliability performance target. In general, the longer the extension, the higher the performance. Some extension towards the side opposite to the direction of the electron flux divergence can also be designed to inhibit voiding due to electron back-flow phenomena, or vacancy migration which is a type of voiding commonly observed in multi level metal systems.

A process for manufacturing the via pad structure of FIG.2 is now provided with reference to FIG.s 4-10. It is to be understood that FIG.s 4-10 are not to scale, that semiconductor 10 is not illustrated and that prior semiconductor processing steps will form active devices in semiconductor wafer 10, or on semiconductor wafer 10 in case of an epitaxial layer, and will form contacts. Also, FIG.s 4a-10a are cross sectional views, FIG.s 5b-10b are end views and FIG.s 4c-10c are top views.

FIG. 4 illustrates metal lead 14'. [The metal lead 14' is a precursor to the above described metal lead 14]. Barrier layer 14a is first formed over semiconductor wafer 10 such as by sputter deposition. The thickness of barrier layer 14a is determined by the design rules as previously explained. In this exemplary flow, TiN forms layer 14a. Conductor layer 14b is next formed on top of layer 14a. Again, sputtering is exemplary to form layer 14b to the desired thickness. In this exemplary flow, Al-Si-Cu forms layer 14b. Next, a thin layer of metal 14e' is formed on top of conductor layer 14b. Layer 14e' provides the metal which will later react with the aluminum alloy conductor layer 14b to form the intermetallic via pad 14e. In this exemplary flow, a thin layer of Ti of about 200-400 angstroms is sputtered onto layer 14b to form layer 14e'.

In FIG.s 5 and 6, metal layer 14e' is patterned for location of the via pads. To pattern metal layer 14e', a resist mask having the desired via pattern is conventionally formed over metal layer 14e' as shown in FIG. 5. A plasma etch then occurs which transfers the pattern to metal layer 14'. A suitable plasma etch, for example, is an RIE etch as may be performed in a commercially available etcher such as an Applied Materials 5000. Suitable etchants include those based upon BCL₃ or CCL₄ chemistries. A short, timed or selective anisotropic etch with only moderate uniformity and selectivity is needed since the pads are very thin. Such a plasma etch will anisotropically etch the portion of metal layer 14e' not covered by the patterned resist mask down to metal layer 14b. The semiconductor wafer is then cleaned to remove the overlying resist and etch residue from the patterned features. This typically occurs by placing the wafer in a solvent or in an oxygen based plasma.

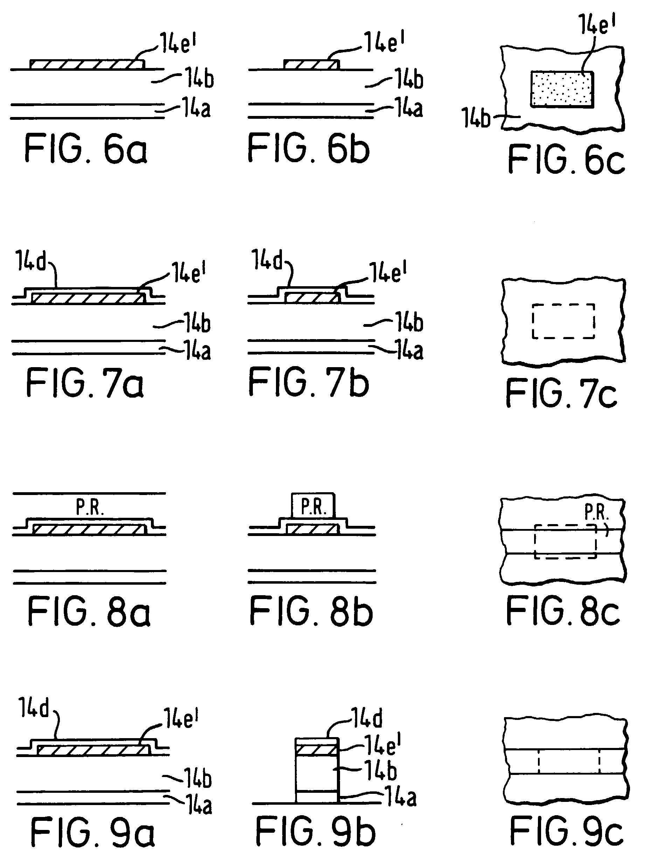

FIG. 7 illustrates the resulting structure following application of a capping layer 14d. A thin antireflective coating 14d is formed over pad 14e' and over conductor layer 14b. In this exemplary flow, about 300 angstroms of TiN is sputtered on top of the Ti layer 14e'.

FIG. 8 illustrates the resulting structure following patterning the leads with photoresist. The leads are conventionally patterned to the desired specifications, such as, for example 0.5 and 0.35 microns. To pattern metal layer 14', a resist mask having the desired linewidth pattern is conventionally formed over metal layer 14'. Since the pads are very thin, there will be no depth of focus problems.

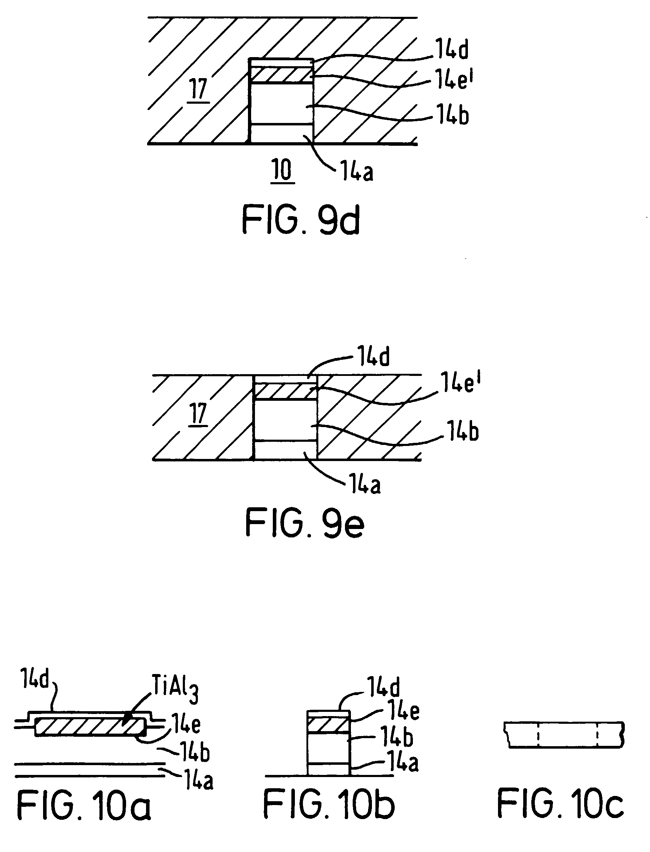

A plasma etch then occurs as illustrated in FIG. 9 which transfers the pattern to metal layer 14'. A plasma etch based upon BCL₃ or CCL₄ chemistries in an etcher such the Applied Materials 5000 will anisotropically etch the portion of metal layer 14' not covered by the patterned resist mask down to a dielectric covering, typically oxide (not illustrated) that covers semiconductor wafer 10. The desired linewidth pattern in the photoresist is thus transferred to metal layer 14'. In a 16MB DRAM application, the width of patterned metal layer 14' is about 0.5 microns. The etch process will etch the pads to produce a self aligned structure; that is, the pads are aligned to the leads. The semiconductor wafer is then cleaned to remove the overlying resist and etch residue from the patterned features. This typically occurs by placing the wafer in a solvent or in an oxygen based plasma.

Next, a series of processing steps occurs which reacts the via pad metal 14e' to form the via pad 14e shown in FIG. 10. Previous to now, the pad metal 14e' is unreacted. It must be heated to form the aluminum/refractory metal compound. In the example where Ti is sputtered as metal 14e', heating it forms TiAl₃. The following discussion provides this series of processing steps.

A dielectric layer 17 is applied to help planarize the topography of the etched leads on the semiconductor wafer as illustrated in the cross section end view of FIG. 9d. Exemplary is an application of spin on glass, SOG. Other suitable planarizing substances include but are not restricted to polyimides of the low k dielectric type As will be explained below, it is desirable that the planarizing dielectric layer have a relatively low curing temperature to avoid damaging the underlying aluminum lines 14'; if the temperature is not high enough to cause the metal 14e' to react with aluminum layer 14b and thereby form the intermetallic metal pad 14e, or there is no curing step during formation of the dielectric layer then the final sintering step typically used in back-end-of line processes is sufficient to promote the formation of the imtermetallic and its associated benefit. The thickness of planarizing dielectric layer 17 is of course dependent upon the height of metal stack 14'.

Turning now to the cross section end view of FIG. 9e, when SOG is used as the planarizing layer, heating it between about 300--400° C is sufficient to densify it. Of course, the time of heating varies according the thickness applied. If, for example, about 3400 Angstroms of SOG were applied, then heating it for about an hour is sufficient. The curing temperature should be below about 450° C to avoid damaging the aluminum metal lines as aluminum starts to "move" at around 500° C. The low k polyimide dielectrics will cure between about 300-350° C.As the planarizing layer 17 is heated, this heats the metal stack 14'. As the metal pad 14e' is heated, it reacts with the underlying aluminum conductor layer 14b and forms an intermetallic. When Ti forms metal pad 14e', heating the titanium atoms causes them to diffuse into the grain boundaries of the quasi-bamboo aluminum lead structure. The 200-400 Angstroms of sputtered Ti of will form an intermetallic 14e of about 500-1500 Angstroms. After stabilizing the planarizing layer, it is etched back to near the top of metal stack 14 to complete planarization as illustrated in FIG. 9e.

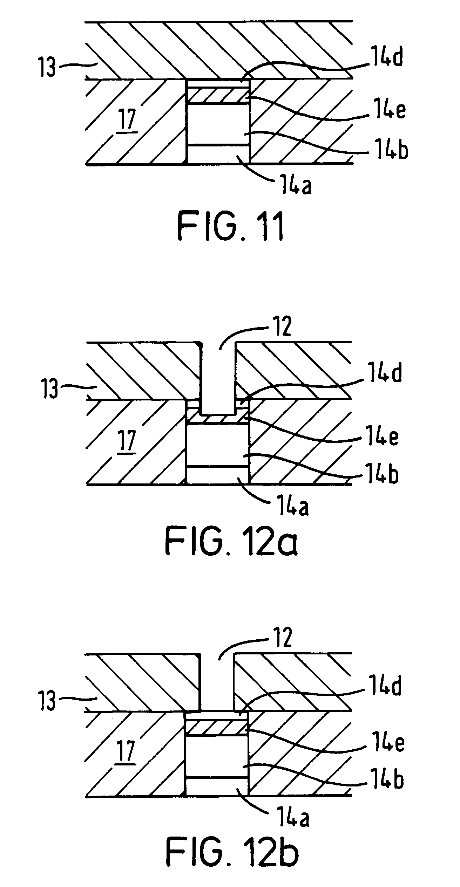

FIG.s 11 and 12 show cross section end views of further processing steps to form the via 12 illustrated in FIG. 2. FIG. 11 reveals the resulting structure following formation of an insulating layer 17. After planarization has occurred, a thick insulating layer such as, for example, plasma enhanced conformal vapor deposited TEOS may be formed to a desired thickness. In 0.5 micron design rules, 10,000 Å of TEOS would be sufficient to form the thick insulating layer 13.

With reference to FIG.s 9d, 9e, 11 and 12 it is to be noted that in an alternative process, it is possible to use a lower temperature planarizing process. In this process, an oxide such as, for example, plasma enhanced conformal vapor deposited TEOS may be formed to a desired thickness. A sinter step could then be used to react the metal 14e' to form the intermetallic pad 14e. The sinter would be subject to the above described temperature constraint of being less than about 450° C. Planarization could then be accomplished by chemical mechanical polish, CMP,, for example, to remove the excess oxide.

FIG. 12 reveals the resulting structure following via pattern and etch. The vias may be conventionally patterned by coating dielectric layer 17 with photoresist and then exposing and developing the resist. An etch step etches through dielectric layer 17. An exemplary oxide etch suitable to open the high aspect ratio vias is one of CHF₃/CF₄ at about 650 mtorr. An oxygen plasma ash will then remove the resist and a solvent clean will remove etch residue.

With reference to FIG. 12a, note that the bottom of via 12 may extend into intermetallic pad 14e. As mentioned in the Background Of The Invention, the etch chemistries are typically not selective to the antireflective coatings 14d and since these coatings are very thin, it is possible to etch into the underlying aluminum 14b when etching the vias 12. This provides undesirable higher via resistance and greater standard deviation across a semiconductor wafer 10 surface. Additionally, etching into the aluminum 14b during the via etch exposes the aluminum 14b to contamination from the etching plasma, the ambient, the cleaning agents necessary to remove etch residues, etc. However, the intermetallic pad 14e or its precursor can advantageously act as a buffer which prevents or repairs damage to the underlying aluminum 14b during via etch and cleanup via plug formation, as well as oxidation. Since 200-400 Angstroms of sputtered Ti 14e' will form an intermetallic pad 14e of about 500-1500 Angstroms, the etch can be optimized to stop within about the first 1000 Angstroms of intermetallic and not reach the underlying aluminum. The intermetallic pad 14e can thus advantageously provide a margin of safety for via etch. Since the intermetallic 14e is not continuous along the length of lead 14 but is localized to the vias, high sheet resistance problems are minimized.

With reference to FIG.2b, note that the bottom of via 12 may stop on or somewhere in the top of ARC layer 14d. This can be accomplished by using newer etch technologies such high density plasmas. In this case the intermetallic 14e still provides a benefit because highly selective etch processes still tend to induce damage to the underlying conductor 14b through "pinholing", "punchthrough", or "trenching" of the ARC layer 14d. The damage becomes noticeable when the via-plugs are formed because the corrosive gases (WF₆ in the case of W-plugs) can reach the underlying conductor through defects in the barrier layer located at the pinholes.

With reference back to FIG. 2a and FIG. 2b, further unillustrated processing steps occur to fill via 12 and create the second level of metal 16. A thin layer 16a of barrier material such as TiN may be sputtered followed by either selective W deposition or blanket conformal vapor deposition of W to fill via 12. If blanket W sputtering is used, a W etch will remove the undesired portion of W over layer 17. This will be followed by suitable steps to create metal layers 16b and 16d such as those described above with reference to forming metal layers 14b and 14d.

As above described, electromigration resistance of lead/via interconnect systems in a case where electrons flow from top-level to bottom-level metals is improved while problems associated with higher lead sheet resistance are minimized. The via pad formed underneath the via having an aluminum/refractory metal compound protects the bottom lead from via etch damage and provides a reservoir of grain boundary dopants. The via pad is advantageously self aligned to the lead by a non-critical lithography step and offers flexible design in asymmetrical or symmetrical shape. Another advantage is that since the added titanium layer is only in the order of a few hundred angstroms, it does not impact processes that are sensitive to the height of the interconnect stack, such as planarization. Additionally, by varying the titanium to aluminum thickness ratio, the aluminum sheet resistance can be optimized.

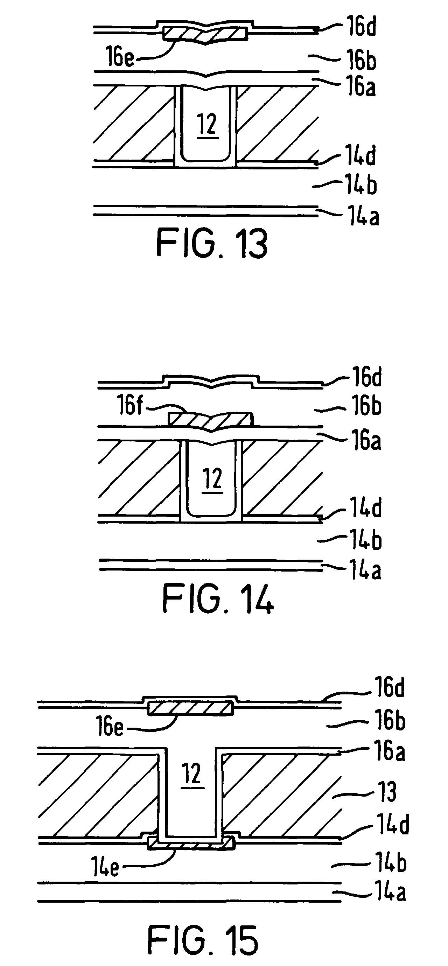

It is possible to improve electromigration resistance of lead/via interconnect systems in the case where electrons flow from bottom-level to top-level metal while minimizing higher sheet resistance. Instead of a pad, located at the bottom of the via, a cap is formed either on top of the upper-level lead as illustrated in the cross section side view of FIG. 13 or directly on top of the via as illustrated in the cross section side view of FIG. 14.

Comparing FIG. 13 to prior art FIG. 1, one sees that the via cap 16e is localized in upper metal layer 16 on top of the via 12. This type of cap can be used in any type of via (stud or reflowed) and may produce better lattice alignment than the cap 16f shown in FIG. 14. Cap 16f of FIG. 14 can be used only on stud or plug vias and is located underneath conductor 16b directly on top of the via plugs. (The barrier layer 16a is optional.) The caps may be produced using the self-aligned process as described above in conjunction with formation of the via pads.

Referring to FIG. 15, via pads and via caps can be combined with via-reflow technology to provide enhanced reliability of all vias regardless of their mode of operation (electron flow up or down the via). Hence, the intermetallic buffer level can be used independently at the pad or cap level or on certain vias selectively according the the mask design. If all pads and caps are symmetrical, then only one mask is needed for both pad and cap levels.

While the invention has been described with reference to illustrative embodiments, this description is not intended to be construed in a limiting sense. Various other embodiments of the invention will be apparent to persons skilled in the art upon reference to this description.

## Claims

1. A buffered pad for a semiconductor device having a via in a dielectric, comprising:
a barrier layer;
a conductor layer formed on the barrier layer;
an intermetallic formed on the conductor and localized to the via in the dielectric; and
an antireflective coating formed between the conductor layer and the dielectric.

2. The buffered pad of claim 1 wherein the intermetallic is asymmetrically shaped.

3. A buffered via cap for a semiconductor device having a via in a dielectric, comprising:
a barrier layer formed on a dielectric and on the via in the dielectric;
an intermetallic formed on the barrier layer and localized to the via in the dielectric;
a conductor layer formed on the barrier layer and covering the intermetallic; and
an anitreflection layer formed on the conductor layer.

4. A buffered via cap for a semiconductor device having a via in a dielectric, comprising:
a barrier layer formed on a dielectric and on the via in the dielectric;
a conductor layer formed on the barrier;
an intermetallic formed on the conductor and localized to the via in the dielectric; and
an anitreflection layer formed on the conductor layer and on the intermetallic.
